# EUROPÄISCHE PATENTSCHRIFT

(11) **EP 1 153 534 B1**
(45) Veröffentlichungstag und Bekanntmachung des Hinweises auf die Patenterteilung: **08.01.2003**
(21) Anmeldenummer: 00910656.8
(22) Anmeldetag: 09.02.2000
(51) Int. Cl.: H05K 7/14, H02B 1/48

(54) **VERTEILERKASTEN**
DISTRIBUTION BOX
BOITE DE DISTRIBUTION

(30) Priorität: 12.02.1999 DE 19905952
(43) Veröffentlichungstag der Anmeldung: 14.11.2001
(73) Patentinhaber: SEW-EURODRIVE GMBH & CO., D-76646 Bruchsal (DE)
(72) Erfinder: ROTH-STIELOW, Jörg, D-75015 Bretten (DE); SCHMIDT, Josef, D-76676 Graben-Neudorf (DE)
(74) Vertreter: Bohnenberger, Johannes, Dr.
(86) Internationale Anmeldenummer: EP0001034
(87) Internationale Veröffentlichungsnummer: WO00048438

(56) Entgegenhaltungen:
- DE-A- 4 437 316
- DE-A- 19 616 551
- DE-A- 19 730 788
- DE-A- 19 816 170

## Beschreibung

Die Erfindung betrifft einen Verteilerkasten nach dem Oberbegriff des Anspruches 1, wie er z. B. aus der DE4437316A bekannt ist.

Bei industriellen Anlagen müssen viele verstreut angeordneten Feldgeräte, insbesondere Antriebe, bestehend aus Elektromotoren mit Umrichtern oder Schalteinrichtungen, von einem Zentralrechner aus ansteuerbar sein. Dazu werden verschiedene Typen von Feldbussen, wie Interbus, Profibus, CANbus oder dergleichen, eingesetzt. Die Feldgeräte werden mit Leitungen für Feldbus verkabelt und besitzen meist eine adressierbare elektronische Steuereinheit, die Daten aus den Feldbus-Signalen herausfiltert, wenn diese für die Adresse des jeweiligen Feldgeräts bestimmt sind.

Die Energie- oder Leistungsversorgung der Feldgeräte erfolgt über Starkstromkabel, insbesondere für Drehstrom.

In manchen Fällen existieren bei Herstellern von Feldgeräten andere Steuerbus-Protokolle, die nicht zu der Klasse der Feldbusse gehören. Als Steuerbus-Protokoll ist bei Fachleuten beispielsweise das Steuerbus-Protokoll MOVILINK der Firma SEW-EURODRIVE GmbH & Co bekannt. Diese Steuerbus-Protokolle sind nicht kompatibel zu den industrieüblichen Feldbus-Protokollen und werden auch als Systembus-Protokolle bezeichnet. Sie können eine sehr hohe Datenübertragungsrate aufweisen. Insbesondere sind bei solchen Steuer- oder System-Bussen die Befehle und Codierungen speziell auf eine Gruppe von Geräten zugeschnitten, insbesondere herrstellerabhängig. Insgesamt kann mit Systembussen die Echtzeitfähigkeit von Anwendungen verbessert werden.

Die Verkabelungen mit Starkstrom und Bussystemen sind aufwendig und kostspielig, besonders auch wegen aufwendiger sternförmiger Verkabelung der Starkstromverdrahtung. Ein wesentlicher Kostenfaktor ist auch die Zeit, die für eine Verkabelung notwendig ist.

Aus der DE 40 05 086 ist eine Anschlusseinheit für Haustechnik bekannt. Das Gehäuse dieser Anschlusseinheit weist eine Auftrennung von elektronischer Schaltung und Verkabelung auf. Dabei ist im Unterteil der Anschlusseinheit die Verkabelung und im Oberteil dieser Anschlusseinheit die elektronische Schaltung montiert. Für industrielle Anlagen ist diese Anschlußeinheit nicht verwendbar.

Der Erfindung liegt die Aufgabe zugrunde, einen Verteilerkasten mit erhöhter Funktionalität aufzuzeigen.

Erfindungsgemäß wird die Aufgabe durch einen Verteilerkasten gelöst mit den Merkmalen nach Anspruch 1.

Wesentliche Merkmale sind bei der Lösung der Aufgabe, dass der Verteilerkasten mit mindestens einer elektronischen Schaltung, insbesondere umfassend Mikroprozessor, Speicher und Logikbausteine und/oder Leistungshalbleiterbauelemente, und mit einem Gehäuse ausgestattet ist, das aufweist:
ein Gehäuseunterteil,
mindestens ein Gehäuseoberteil, das dicht und fest, also in hoher Schutzart, mit dem Gehäuseunterteil verbindbar ist,
zumindest eine Übergabe-Steckereinrichtung, die ein jeweiliges erstes und zweites Steckverbinderteil umfasst und deren jeweiliges erstes Steckverbinderteil derart in ein Gehäuseoberteil fest montiert ist, dass es beim Aufsetzen dieses Gehäuseoberteils auf das Gehäuseunterteil mit einem jeweiligen zweiten, zum jeweiligen ersten passenden und im Gehäuseunterteil fest montierten Steckverbinderteil der Übergabe-Steckereinrichtung in Kontaktverbindung bringbar ist,
wobei im Gehäuseunterteil Verbindungseinrichtungen oder Anschlusseinrichtungen zum Anschluß externer Leitungen, wie Klemmleisten oder dergleichen, zum Verbinden einer Verkabelung mit zumindest dem jeweiligen zweiten Steckverbinderteil montiert sind. Weiterhin ist hierbei vorgesehen, dass
das Gehäuseunterteil eine T-förmige Verkabelung für Starkstrom, wie Drehstrom, zwischen zwei externen Anschlussmöglichkeiten und einer externen Anschlussmöglichkeit für ein Hybridkabel am Gehäuseunterteil aufweist,
das Gehäuseunterteil eine T-förmige Verkabelung für Feldbus zwischen zwei externen Anschlussmöglichkeiten am Gehäuseunterteil und zumindest einem zweiten Steckverbinderteil aufweist,
in mindestens einem Gehäuseoberteil eine elektronische Schaltung montiert ist, die über ein erstes und zweites Steckverbinderteil mit einem Steuerbus elektrisch verbindbar ist,
das Gehäuseunterteil eine externe Anschlussmöglichkeit für ein Hybridkabel mit Hybridsteckverbinderteil aufweist, das Starkstrom- und Schwachstromleitungen umfasst,
und dass die Schwachstromleitungen des Hybridkabels mit zumindest einer elektronischen Schaltung eines Gehäuseoberteils verbindbar sind.

Somit ist als Vorteil eine sehr einfache kostengünstige Verkabelung ermöglicht. Insbesondere sind Teile vormontierbar und vorfertigbar, müssen also nicht erst in der Anlage aufgebaut werden. Durch die Übergabe-Steckereinrichtung und Steckverbinderteile ist ein besonders schnelles, sicheres und einfaches Verbinden von Gehäuseteilen ermöglicht. Insbesondere auch durch den Einsatz der Hybridsteckverbinderteile ist ein zeitsparendes Schließen und Trennen von Starkstrom und Schwachstromleitungen ermöglicht. Die Verlegung des Hybridkabels erspart Zeit und erhöht außerdem die Übersichtlichkeit der gesamten Verkabelung, da Starkstrom- und Schwachstromkabel nicht mehr einzeln verlegt werden müssen.

Ein besonders wesentliches Merkmal der Erfindung ist, dass die Leitungen des Feldbusses elektrisch durchgeschleift werden und daher vorteilhafterweise ringförmige Struktüren der Verkabelung für Feldbusse ermöglicht werden. Ebenso ist ein wesentliches Merkmal der Erfindung, dass der Starkstrom T-förmig verkabelt wird und die Abzweigung zum betriebenen Feldgerät, mittels eines Hybridkabels ermöglicht wird. Daher wird auch für den Starkstrom eine ringförmige Verkabelung ermöglicht. Von Vorteil ist dabei, dass solche Verkabelungen deutlich kostengünstiger und materialsparender ausführbar sind.

Dabei ist unter Feldgerät ein Elektromotor mit Umrichter, ein Elektromotor mit einer einfachen Schalteinrichtung zum Ein- und Ausschalten, ein Elektromotor mit Sanftanlaufgerät oder dergleichen zu verstehen.

Unter Durchschleifen ist zu verstehen, dass ein von außen kommendes Kabel mit Leitungen an eine externe Anschlusseinrichtung im Verteilerkasten angeschlossen wird und dann über eine interne Verkabelung mit einer weiteren externen Anschlusseinrichtung im Verteilerkasten elektrisch verbunden ist, an die wieder ein von außen kommendes Kabel mit Leitungen angeschlossen ist.

Unter T-förmiger Verkabelung ist dabei zu verstehen, dass ein von außen kommendes Kabel mit Leitungen an eine externe Anschlusseinrichtung im Verteilerkasten angeschlossen wird und dann über eine interne Verkabelung mit mindestens zwei weiteren externen Anschlusseinrichtungen im Verteilerkasten elektrisch verbunden ist, an die wiederum von außen kommende Kabel mit Leitungen anschließbar sind. Eine der genannten externen Anschlusseinrichtungen ist für ein Hybridkabel ausgelegt, das Starkstrom- und Steuerbus-Leitungen umfasst.

Ein weiteres Merkmal der Erfindung besteht darin, dass im Gehäuseunterteil Verkabelungen und Anschlusseinrichtungen fest und störunanfällig montiert sind und im Gehäuseoberteil die zu wartende, zu reparierende oder den örtlichen Gegebenheiten anzupassende bzw. umzurüstende Elektronik sitzt. Durch diese Trennung ist es möglich, selbst bei rauhen Feldbedingungen an sich hochkomplizierte Wartungsarbeiten durchzuführen, indem einfach ein Gehäuseoberteil durch ein intaktes bzw. veränderten Bedingungen oder Erfordernissen angepaßtes Gehäuseoberteil mit entsprechender Elektronik ersetzt wird. Hierbei kann gleichzeitig ein hoher Schutzart-Standard Anwendung finden, was ebenfalls insbesondere durch die mechanische und elektrische Trennung zwischen Oberteil und Unterteil erleichtert wird.

Insgesamt umfasst somit der Verteilerkasten zumindest eine elektronische Schaltung, insbesondere eine solche mit Mikroprozessor, Speicher- und Logikschaltung, und ein Gehäuse, wobei das Gehäuse ein Gehäuseunterteil, zumindest ein Gehäuseoberteil, das dicht und fest verbindbar ist und eine Übergabe-Steckereinrichtung umfasst, deren erstes Steckverbinderteil derart am Gehäuseoberteil fest montiert ist, dass es beim Aufsetzen eines Gehäuseoberteils auf das Gehäuseunterteil mit einem zweiten, im Gehäuseoberteil fest montierten Steckverbinderteil der Übergabe-Steckereinrichtung in Kontaktverbindung gebracht wird. Hierbei sind im Gehäuseunterteil Anschlusseinrichtungen zum Anschluß externer Leitungen, wie Klemmleisten oder dergleichen zum Verbinden einer Verkabelung mit dem zweiten Steckverbinderteil und im Gehäuseoberteil die elektronische Schaltung untergebracht.

Die Schwachstromleitungen umfassen einerseits vorzugsweise Bremsenleitungen zur Ansteuerung eines Elektromotors mit Bremse, wobei die Bremsenleitungen mit derjenigen elektronischen Schaltung verbindbar sind, die einen Umrichter umfasst und zumindest mit Steuerbusleitungen verbindbar ist, oder andererseits Steuerbusleitungen, wobei die Steuerbusleitungen des Hybridkabels mit den Steuerbusleitungen derjenigen elektronischen Schaltung verbindbar sind, die mit dem Feldbus elektrisch verbunden ist. Von Vorteil ist dabei, dass in beiden Fällen derselbe Typ von Hybridkabel verwendbar ist und sich somit insgesamt Kosteneinsparungen ergeben.

Vorzugsweise stellt die Übergabe-Steckereinrichtung die einzige elektrische Verbindung zwischen der Verkabelung im Gehäuseunterteil und der elektronischen Schaltung im jeweiligen Gehäuseoberteil dar. Eine Reparatur oder ein Austausch der Elektronik kann daher durch einfachen Austausch von Gehäuseoberteilen mit wenigen Handgriffen geschehen, wobei die Gehäuseoberteile mit der eingebauten Elektronik in einer geeigneten Umgebung, also nicht im Feld, aufgebaut bzw. umgebaut werden.

Bei einer weiteren bevorzugten Ausgestaltung weist der Verteilerkasten ein Erdungsverbindungskabel zwischen jeweiligem Gehäuseoberteil und Gehäuseunterteil auf. Somit stellen die Übergabe-Steckereinrichtung und das Erdungsverbindungskabel die einzige elektrische Verbindung zwischen Gehäuseoberteil und Gehäuseunterteil dar. Von Vorteil ist dabei die Erdung des Gehäuseoberteils auch nach Öffnen bzw. Abheben des Gehäuseoberteils.

Die Feldbus-Leitungen als Schwachstromleitungen umfassen in einer vorteilhaften Ausgestaltung auch Leitungen für Versorgungsspannungen, wie 24V-Versorungsleitungen oder dergleichen. Auch Abschirmungen und Erdungsleitungen können hierzu hinzugezählt werden. Von Vorteil ist dabei, dass die Feldbus-Leitungen mit Leitungen für Versorgungsspannungen unterschieden werden von den Starkstromverdrahtungen und zusammen mit den Feldbus-Leitungen verkabelt werden können.

In einer Weiterbildung weist das Gehäuseunterteil einen Motorschutzschalter auf. Von Vorteil ist dabei, dass für Montage-, Reparatur- oder Installationszwecke die Starkstromversorgung des vom Verteilerkasten versorgten Feldgerätes oder der vom Verteilerkasten versorgten Feldgeräte unterbrochen werden kann.

In einer vorteilhaften Weiterbildung weist das Gehäuseunterteil einen Hilfsschalter auf, der an den Motorschutzschalter mechanisch gekoppelt ist. Der Motroschutzschalter trennt die Starkstromleitungen elektrisch ab. Der Hilfsschalter trennt wegen der mechanischen Kopplung ungefähr gleichzeitig die Feldbus-Leitungen und die Versorgungsspannungsleitungen elektrisch ab. Von Vorteil ist dabei, dass das vom Verteilerkasten versorgte Feldgerät oder die vom Verteilerkasten versorgten Feldgeräte elektrisch völlig abtrennbar sind.

In einer vorteilhaften Ausgestaltung ist die elektronische Schaltung derart gestaltet, dass sie als Busteilnehmer adressierbar ist und die für diese Adresse bestimmten Daten aus dem Feldbus herausfiltert, in ein Steuerbusprotokoll umsetzt und die umgesetzten Daten über den Steuerbus an das vom Verteilerkasten versorgte Feldgerät oder die vom Verteilerkasten versorgten Feldgeräte weitergeben kann.

Bei einer weiteren bevorzugten Ausgestaltung umfasst ein erstes Gehäuseoberteil eine elektronische Schaltung, die elektrisch mindestens mit dem Feldbus und dem Systembus verbunden ist. Von Vorteil ist dabei, dass die elektronische Schaltung als Busumsetzer ausführbar ist und schnell austauschbar ist mittels der erwähnten Steckverbinderteile. Somit kann sogar durch Austausch dieses Gehäuseoberteiles mit elektronischer Schaltung ein Wechsel eines Bussystems durchgeführt werden.

Bei einer anderen bevorzugten Ausgestaltung weist der Verteilerkasten ein zweites Gehäuseoberteil zur Bildung eines abgeschlossenen Raumbereiches auf. Von Vorteil ist dabei, dass durch Abheben des Gehäuseteils der Raumbereich der externen Anschlussvorrichtungen zugänglich wird und notwendige Verkabelungen durchführbar sind. Nach Abschluss dieser Verkabelungsarbeiten wird das Gehäuseoberteil wieder aufgesetzt und somit das Gehäuse vorteilhafterweise wiederum dicht und fest, also in hoher Schutzart geschlossen.

Bei einer weiteren bevorzugten Ausgestaltung umfasst der Verteilerkasten ein drittes Gehäuseoberteil mit einer elektronischen Schaltung, die elektrisch mindestens mit dem Systembus und Bremsenleitungen verbindbar ist. Von Vorteil ist dabei, dass die elektronische Schaltung als Umrichter ausführbar ist und somit der Verteilerkasten einen Elektromotor versorgen, steuern und regeln kann.

Bei einer weiteren bevorzugten Ausgestaltung umfasst das Gehäuseunterteil einen Bremswiderstand eines Umrichters und der Bremswiderstand ist mit der elektronischen Schaltung des dritten Gehäuseoberteils elektrisch verbunden. Von Vorteil ist dabei, dass in den Verteilerkasten ein Bremswiderstand integrierbar ist und das Gehäuse des Verteilerkastens sogar zur Ableitung der Wärme des Bremswiderstandes verwendbar ist. Das Gehäuse stellt somit eine gleichzeitig Kühlvorrichtung dar.

Vorzugsweise umfasst der Verteilerkasten mindestens eine elektronische Schaltung, insbesondere umfassend Mikroprozessor, Speicher und Logikbausteine und/oder Leistungshalbleiterbauelemente, und ein Gehäuse, umfassend
ein Gehäuseunterteil,
mindestens ein Gehäuseoberteil, das dicht und fest, also in hoher Schutzart, mit dem Gehäuseunterteil verbindbar ist,
zumindest eine Übergabe-Steckereinrichtung, die ein jeweiliges erstes und zweites Steckverbinderteil umfasst und deren jeweiliges erstes Steckverbinderteil derart in ein Gehäuseoberteil montiert ist, dass es beim Aufsetzen dieses Gehäuseoberteils auf das Gehäuseunterteil mit einem jeweiligen zweiten, zum jeweiligen ersten passenden und im Gehäuseunterteil montierten Steckverbinderteil der Übergabe-Steckereinrichtung in Kontaktverbindung bringbar ist,
wobei im Gehäuseunterteil Verbindungseinrichtungen und/oder Anschlusseinrichtungen zum Anschluß externer Leitungen, wie Klemmleisten oder dergleichen, zum Verbinden einer Verkabelung mit zumindest dem jeweiligen zweiten Steckverbinderteil montiert sind,
wobei das Gehäuse mit einem Bremswiderstand eines Umrichters in thermisch leitender Verbindung steht,

Von Vorteil ist dabei, dass in den Verteilerkasten ein Bremswiderstand integrierbar ist und das Gehäuse des Verteilerkastens sogar zur Ableitung der Wärme des Bremswiderstandes verwendbar ist. Das Gehäuse stellt somit eine gleichzeitig Kühlvorrichtung dar. Somit ist der Bremswiderstand schon bei der Fertigung montierbar und es entfallen Kosten für Installation, Montage, Verkabelung oder dergleichen. Außerdem muss kein zusätzlicher Montageplatz für den Bremswiderstand bereitgestellt werden.

Bei einer weiteren bevorzugten Ausgestaltung ist der Bremswiderstand im Innern des Gehäuses montiert. Von Vorteil ist dabei, dass das Gehäuse Schutzfunktionen übernimmt, wie Personen- und Berührschutz wegen hohen Temperaturen. Außerdem ist das Gehäuse mit der Erde elektrisch verbindbar und stellt somit einen elektrischen Schutz dar. Bei einer weiteren vorzugsweisen Ausgestaltung ist das Gehäuse aus Kunststoff ausgeführt. Vorteilhaft ist dabei, dass sogar zusätzlich eine Isolierfunktion durch das Gehäuse ausführbar ist.

Bei einer weiteren bevorzugten Ausgestaltung ist das Gehäuse zur Abgabe von Wärme ausgebildet ist, insbesondere Kühlfinger und/oder Kühlrippen aufweist. Von Vorteil ist dabei, dass das Gehäuse des Verteilerkastens Wärmeleistung schnell an die Umgebung abgeben kann, also einen geringen Wärmeübergangswiderstand zur Umgebung hin aufweist, insbesondere vom Wärmewiderstand aus.

Vorzugsweise umfasst der Verteilerkasten mindestens eine elektronischen Schaltung, insbesondere umfassend Mikroprozessor, Speicher und Logikbausteine und/oder Leistungshalbleiterbauelemente, und ein Gehäuse, umfassend
ein Gehäuseunterteil,
mindestens ein Gehäuseoberteil, das dicht und fest, also in hoher Schutzart, mit dem Gehäuseunterteil verbindbar ist,
zumindest eine Übergabe-Steckereinrichtung, die ein jeweiliges erstes und zweites Steckverbinderteil umfasst und deren jeweiliges erstes Steckverbinderteil derart in ein Gehäuseoberteil montiert ist, dass es beim Aufsetzen dieses Gehäuseoberteils auf das Gehäuseunterteil mit einem jeweiligen zweiten, zum jeweiligen ersten passenden und im Gehäuseunterteil montierten Steckverbinderteil der Übergabe-Steckereinrichtung in Kontaktverbindung bringbar ist,
wobei im Gehäuseunterteil Verbindungseinrichtungen und/oder Externe Anschlusseinrichtungen, wie Klemmleisten oder dergleichen, zum Verbinden einer Verkabelung mit zumindest dem jeweiligen zweiten Steckverbinderteil montiert sind,
wobei im Gehäuseunterteil Verbindungseinrichtungen und/oder Anschlusseinrichtungen zum Anschluß externer Leitungen, wie Klemmleisten oder dergleichen, zum Verbinden einer Verkabelung mit zumindest dem jeweiligen zweiten Steckverbinderteil montiert sind,
wobei ein zweites Gehäuseoberteil zusammen mit mindestens dem Gehäuseunterteil derart einen inneren Raumbereich des Gehäuses des Verteilerkastens gegen die Umgebung abschließt oder zugänglich macht, dass die Verbindungseinrichtungen und/oder die Anschlusseinrichtungen zum Anschluß externer Leitungen zugänglich sind.

Von Vorteil ist dabei, dass für das Verbinden der Verkabelung, beispielsweise bei Montage, Wartung oder Inbetriebnahme, durch Lösen des zweiten Gehäuseoberteils die Verbindungseinrichtungen und/oder die Anschlusseinrichtungen zum Anschluß externer Leitungen zugänglich und veränderbar sind.

Bei einer weiteren vorzugsweisen Ausgestaltung ist das zweite Gehäuseunterteil das einzige Teil, das vom Gehäuseunterteil gelöst werden muss, um die Verbindungseinrichtungen und/oder die Anschlusseinrichtungen zum Anschluß externer Leitungen zugänglich zu machen.
Von Vorteil ist dabei, dass nur ein Teil gelöst, also beispielsweise losgeschraubt, werden muss. Dies spart Zeit und damit auch Kosten bei Wartung, Montage und Installation.

Weitere vorteilhafte Ausgestaltungen ergeben sich aus den Unteransprüchen.

### Bezugszeichenliste

- 1: Gehäuseoberteil
- 2: Gehäuseunterteil
- 3: PG-Verschraubung für Feldbus und Versorgungsspannungen
- 4: PG-Verschraubung für Starkstrom
- 5: Schrauben
- 6: PG-Verschraubung für Hybridkabel
- 7: Hybrid-Steckverbinderteil
- 14: Anzeigeelemente
- 21: zweites Steckverbinderteil
- 22: Anschlusseinrichtungen zum Anschluß externer Leitungen
- 23: erstes Steckverbinderteil
- 24: Platine
- 25: Anschlusseinrichtungen zum Anschluß externer Leitungen
- 31: Motorschutzschalter
- 41: Feldbus-Kabel
- 42: Starkstrom-Kabel
- 43: Hybridkabel
- 44: Versorgungskabel
- 45: Umrichter
- 46: Elektromotor
- 51: erstes Gehäuseoberteil
- 52: zweites Gehäuseoberteil
- 53: drittes Gehäuseoberteil
- 54: Motorschutzschalter
- 55: Gehäuseunterteil
- 56: Hybridsteckverbinderteil
- 57: große Bohrungen
- 58: kleine Bohrungen
- 59: Typenschild
- 60: Kühlvorrichtung
- 61: zweites Steckverbinderteil
- 62: Anschlussvorrichtungen
- 63: Steckverbinder
- 68: Platine

Die Erfindung wird anhand von Abbildungen näher erläutert. Hierbei zeigt
- Fig. 1 eine perspektivische Darstellung eines ersten Ausführungsbeispiels der Erfindung.
- Fig. 2 eine perspektivische Darstellung des ersten Ausführungsbeispiels der Erfindung mit abgehobenem Gehäuseoberteil.
- Fig. 3 eine perspektivische Darstellung eines zweiten Ausführungsbeispiels der Erfindung.
- Fig. 4 eine perspektivische Darstellung für ein Verkabelungsschema für das erste Ausführungsbeispiel mit separatem Umrichter und Elektromotor.
- Fig. 5 eine perspektivische Darstellung eines dritten Ausführungsbeispiels der Erfindung.
- Fig. 6 eine perspektivische Darstellung des dritten Ausführungsbeispiels mit abgehobenem Gehäuseoberteil.

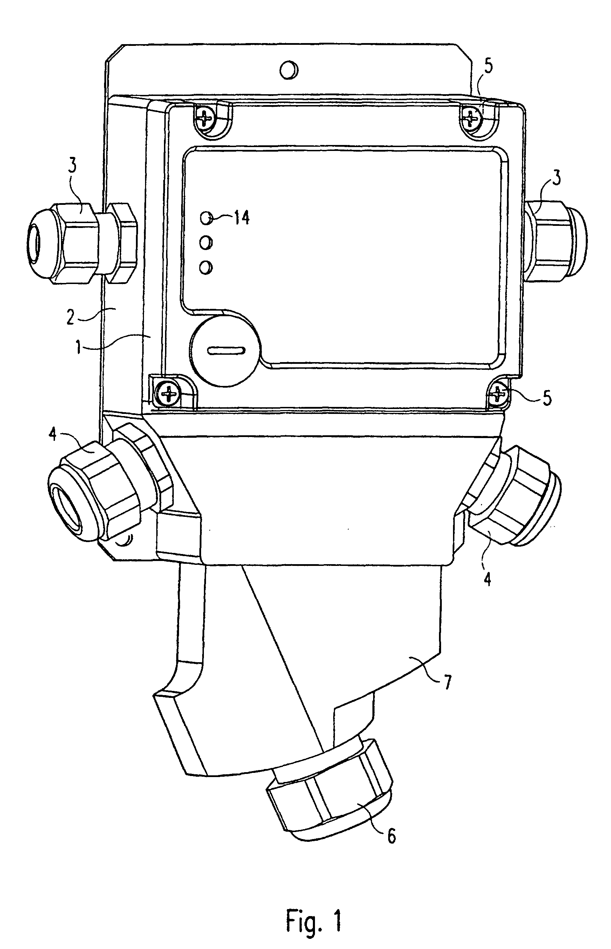

In der Figur 1 ist eine Ausführungsform des erfindungsgemäßen Verteilerkastens gezeigt. Er umfasst ein Gehäuseunterteil 2 und ein Gehäuseoberteil 1. Feldbuskabel mit Feldbus-Leitungen und Versorgungsspannungsleitungen führen durch die PG-Verschraubungen 3 und Auslassungen in der Gehäusewand ins Innere des Gehäuseunterteils 2. Ebenso führen Starkstromkabel durch PG-Verschraubungen 4 ins Innere des Gehäuseunterteils 2. Das Gehäuseoberteil 1 wird mittels lösbarer Schrauben 5 mit dem Gehäuseunterteil fest verbunden. An der Trennfläche zwischen Gehäuseoberteil 1 und Gehäuseunterteil 2 ist eine Dichtung angebracht, so dass die Verbindung der beiden Gehäuseteile in hoher Schutzart erfolgt. Die elektrische Verbindung von Gehäuseoberteil 1 und Geäuseunterteil 2 erfolgt mittels zweier Steckverbinderteile, die in der Figur nicht gezeigt sind.

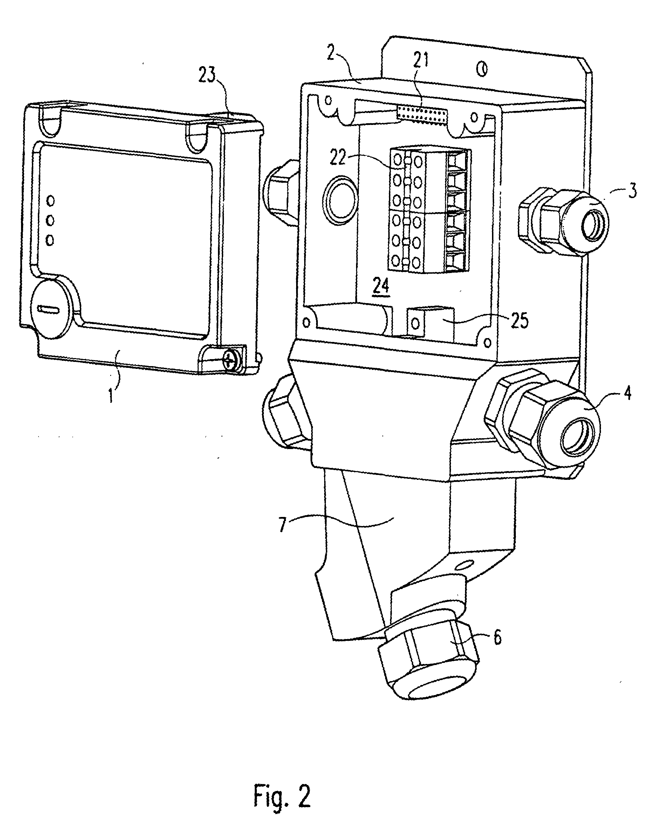

Ein vom Feldgerät oder von Feldgeräten herführendes Hybridkabel wird durch die PG-Verschraubung 6 geführt und mit einem handelsüblichen Hybrid-Steckverbinderteil 7 verbunden. Dieser wird in ein entsprechendes Hybrid-Steckverbinderteil als externe Anschlusseinrichtung des Gehäuseunterteils 2 gesteckt, wobei dieses Hybrid-Steckverbinderteil mit einer Platine (vergl. Figur 2, 24) des Gehäuseunterteils 2 verlötet und somit im Gehäuseunterteil 2 integriert ist.

Das Gehäuseoberteil 1 umfasst eine elektronische Schaltung, die mit den Feldbus-Leitungen und mit Leitungen des Hybridkabels elektrisch verbunden ist. Ein Zentralrechner und gegebenenfalls andere Feldgeräte sind somit elektrisch über Feldbus mit der elektronischen Schaltung des Gehäuseoberteils 1 verbunden. Die elektronische Schaltung des Gehäuseoberteils 1 weist eine mit DIP-Schaltern einstellbare Feldbus-Teilnehmer-Adresse auf und filtert Daten, die für diese spezielle Adresse bestimmt sind, heraus. Des weiteren setzt sie diese Daten in ein Systembusprotokoll um und überträgt die umgesetzten Systembus-Daten über Leitungen des Hybridkabels an zumindest einen ans Hybridkabel angeschlossenen Umrichter. Analog werden Daten in umgekehrter Reihenfolge ins Feldbusprotokoll umgesetzt.

Weitere Umrichter oder Geräte sind an diesem Systembus anschließbar und können auch untereinander Daten austauschen. Vorteilhaft ist dabei, dass der Systembus für eine sehr hohe Datenübertragungsrate auslegbar ist und somit spezielle Anwendungen, wie elektronische Kurvenscheibe oder dergleichen, in guter Qualität ausführbar sind.

In der Figur 2 ist derselbe Verteilerkasten wie bei Figur 1 skizziert, wobei das Gehäuseoberteil 1 abgehoben gezeigt ist und die Platine 24 zu sehen ist, mit der das vorgenannte Hybrid-Steckverbinderteil verlötet ist. Auf der Platine 24 befinden sich weitere Anschlusseinrichtungen 22, 25 zum Anschluss externer Leitungen wie Feldbus-Leitungen, Versorgungsspannungsleitungen, Starkstrom-Leitungen, Abschirmungsleitungen und Nullleiter-Leitungen.

Das erste Steckverbinderteil 23 ist im Gehäuseoberteil 1 montiert und mit der elektronischen Schaltung des Gehäuseoberteils 1 elektrisch verbunden. Das zweite Steckverbinderteil 21 ist auf der Platine 24 aufgesetzt und mittels Lötverbindung elektrisch mit dieser verbunden. Aus dem ersten Steckverbinderteil 23 und dem zweiten Steckverbinderteil 21 wird somit eine Übergabe-Steckereinrichtung gebildet, die bis auf ein Erdungsverbindungskabel die einzige elektrische Verbindung zwischen Gehäuseoberteil 1 und Gehäuseunterteil 2 darstellt.

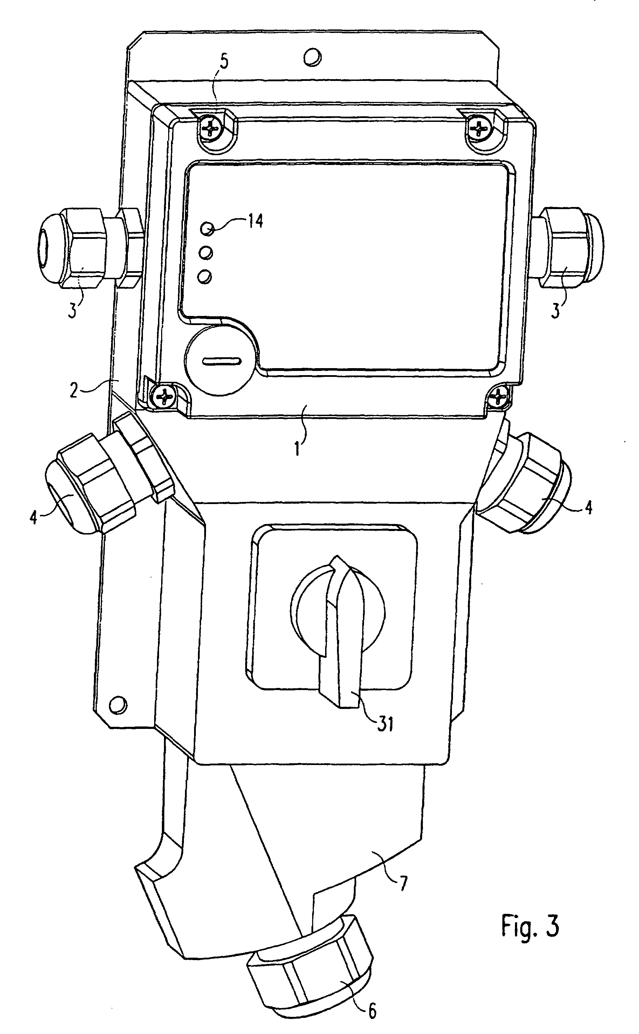

In der Figur 3 ist eine vorteilhafte Weiterbildung gezeigt, die einen Motorschutzschalter 31 zur elektrischen Trennung der Starkstrom-Leitungen aufweist. Dieser ist mit dem Gehäuseunterteil 2 verbunden und besitzt einen Hilfsschalter zur elektrischen Trennung der Feldbus-Leitungen mit Versorgungsspannnungs-Leitungen. Der Hilfsschalter dient hierbei also zum elektrischen Auftrennen von Schwachstromleitungen. Während der Installation, Montage oder Reparatur kann somit die gesamte Hybridverkabelung mit angeschlossenen Feldgeräten, wie Umrichter mit Elektromotoren oder dergleichen, elektrisch abgeschaltet werden.

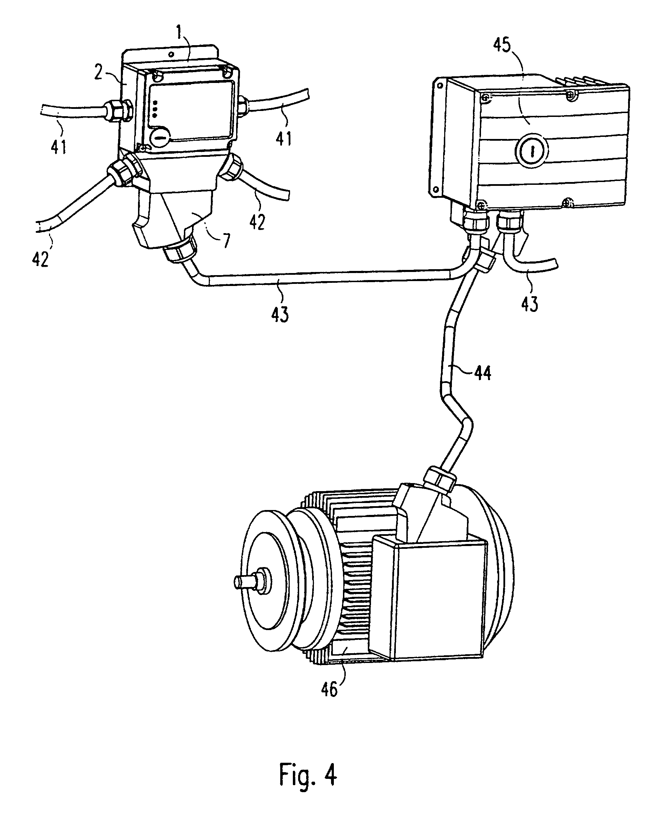

In der Figur 4 ist der Anschluss eines Feldgerätes an den erfindungsgemäßen Verteilerkasten nach Figur 1 und 2 gezeigt. Durch das Gehäuseunterteil 2 ist das Feldbus-Kabel elektrisch durchgeschleift, wobei die elektronische Schaltung im Gehäuseoberteil 1 den Feldbus anzapft und die für die eingestellte Adresse bestimmten Daten umsetzt in ein Steuerbusprotokoll. Die Starkstrom-Kabel 42 sind ebenfalls T-förmig durchgeschleift, wobei die Starkstrom-Leitungen des Hybridkabels 43 mit den Starkstromkabeln 42 verbunden sind. Das Hybridkabel 43 führt Starkstrom und Steuerbus zum Umrichter und wird durch den Umrichter 45 durchgeschleift. Somit können weitere Feldgeräte, wie Umrichter 45 mit Elektromotoren 46 oder dergleichen, angeschlossen werden. Der Umrichter 45 versorgt über das Versorgungskabel 44 den Elektromotor 46.

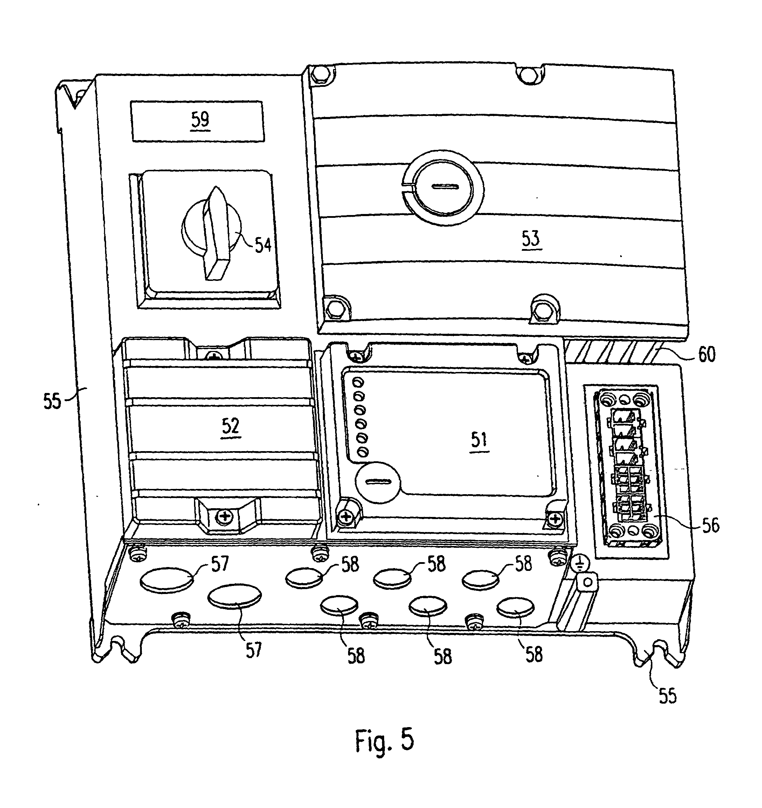

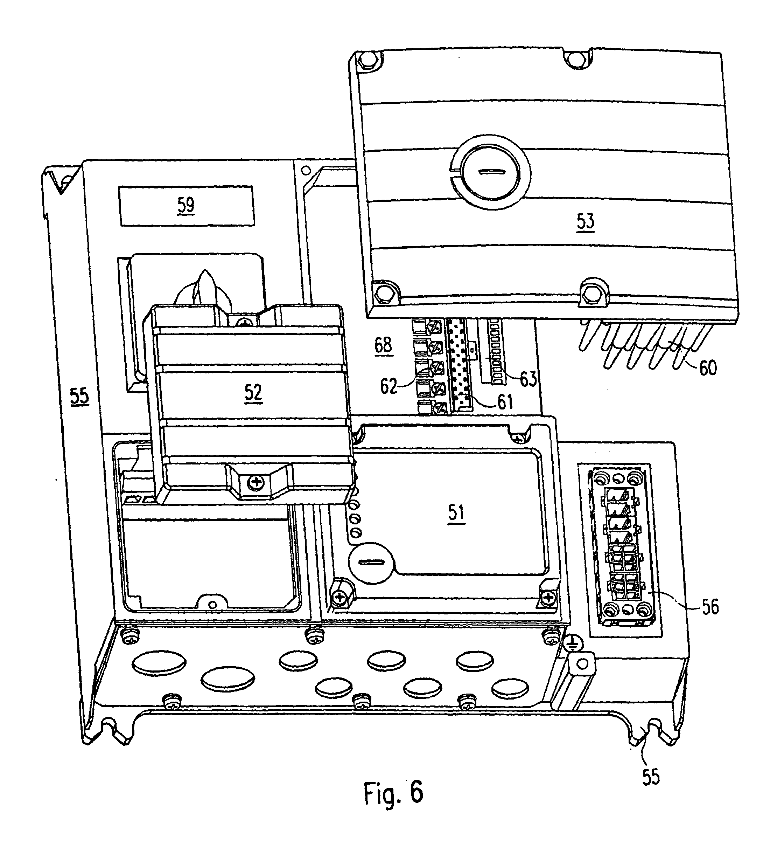

In den Figuren 5 und 6 ist ein weiteres erfindungsgemäßes Ausführungsbeispiel gezeigt. Es umfasst ein Gehäuseunterteil 55, auf das mehrere Gehäuseoberteile 51, 52, 53 aufgesetzt und mit Schrauben lösbar mit dem Gehäuseunterteil 55 in hoher Schutzart verbunden sind. Figur 5 zeigt dabei die Gehäuseoberteile 51, 52, 53 in aufgesetztem Zustand, Figur 6 zeigt dabei das zweite und dritte Gehäuseoberteil 52,53 in abgehobenem Zustand. Des Weiteren befinden sich ein Typenschild 59 und ein Motorschutzschalter 54 auf dem Gehäuseunterteil 55.

Das Gehäuseunterteil 55 weist zwei große Bohrungen 57 für Starkstromleitungen und kleine Bohrungen 58 zur Aufnahme von PG-Verschraubungen für Feldbus-Leitungen auf. Die Starkstromleitungen sind ebenso wie die Feldbus-Leitungen T-förmig durchgeschleift. Bei Montage wird also eine der Starkstromleitungen als Zuleitung durch eine der großen Bohrungen 57 hindurchgeführt und an eine Klemmenleiste angeschlossen wird, die auf der Platine 68 des Gehäuseunterteils 55 aufsitzt und Lötverbindungen zur Platine 68 aufweist. Umgekehrt wird in gleicher Weise ein Starkstromkabel als Ableitung durch eine der großen Bohrungen 57 hindurchgeführt und an die Klemmenleiste angeschlossen. Der Drehstrom wird daher von der Zuleitung über die Ableitung zu weiteren Geräten geleitet. Über die Platine 68 ist es jedoch auch möglich Drehstrom an das Hybridsteckverbinderteil 56 als externe Anschlussmöglichkeit abzuzweigen und damit einen dort angeschlossenen Elektromotor zu versorgen.

Das erste Gehäuseoberteil 51 umfasst wie in Figur 1 und Figur 2 eine elektronische Schaltung im ersten Gehäuseoberteil 51, die mit Feldbus-Leitungen elektrisch verbunden ist und diejenigen Daten aus dem Feldbusdatenstrom herausfiltert, die für die mit DIP-Schaltern einstellbare Adresse bestimmt sind. Diese Daten werden danach ins Systembusprotokoll umgesetzt und über den Systembus an einen an den Systembus angeschlossenen Umrichter weitergeleitet. In der Figur 5 und 6 ist der Umrichter als drittes Gehäuseoberteil 53 ausgeführt, das die entsprechende elektronische Schaltung mit Leitungselektronik enthält, deren Wärme über die Kühlvorrichtung 60 abgeführt wird. Die elektrischen Verbindungen zum Gehäuseunterteil werden über einen Steckverbinder mit zweitem Steckverbinderteil 61 hergestellt. Die Anschlussvorrichtungen 62 dienen zum Anschluss des Motorschutzschalters 54. Der Steckverbinder 63 stellt eine Verbindung zum Hybridsteckverbinderteil 56 her, wobei zumindest die Starkstromleitungen, Leitungen zur Versorgung der Bremse des Motors, also Bremsenleitungen, und Temperaturfühler-Leitungen und Nullleiter auf das Hybridsteckverbinderteil 56 geführt werden.

Wiederum ist mit dem Motorschutzschalter 54 ein Hilfsschalter gekoppelt, der im Wesentlichen gleichzeitig zum Motorschutzschalter 54 schaltet. Er dient also zum elektrischen Auftrennen von Schwachstromleitungen, wie auch Motorsteuerleitungen.

Das Hybridsteckverbinderteil 56 umfasst bei den Figuren 5 und 6 einerseits Starkstromkabel für große Ströme und auch Spannungen. Andererseits umfasst es Leitungen, die nur kleinere Ströme, also Schwachströme, und auch Spannungen führen können. Daher ist ein Kabel mit Leitungen verschiedener Durchmesser vorteilhaft einsetzbar, insbesondere unter Verwendung von Hybridsteckverbindungen wie beispielhaft das Hybridsteckverbinderteil 56, da auf diese Weise der Installationsaufwand erheblich verringerbar ist.

Bei abgehobenem zweiten Gehäuseoberteil 52 sind die Anschlussvorrichtungen für die Zuleitung und Ableitung aus Starkstromleitungen ebenso zugänglich wie die Zu- und Ableitungen der Feldbus- und sonstigen Leitungen. Diese Anschlussvorrichtungen werden auch als externe Anschlussvorrichtungen bezeichnet, da sie zum Anschluss von externen Leitungen dienen.

Im Gehäuseunterteil 55 ist auch ein Bremswiderstand montiert, der an die Anschlussvorrichtungen 62 elektrisch angeschlossen ist und somit mit der elektronischen Schaltung des dritten Gehäuseoberteils 53, das als aufsteckbarer Umrichter gestaltet ist, verbindbar ist.

## Patentansprüche

1. Verteilerkasten mit mindestens einer elektronischen Schaltung, insbesondere umfassend Mikroprozessor, Speicher und Logikbausteine und/oder Leistungshalbleiterbauelemente, mit einem Gehäuse, umfassend
ein Gehäuseunterteil (2, 55),
mindestens ein Gehäuseoberteil (1,51,52,53), das dicht und fest, also in hoher Schutzart, mit dem Gehäuseunterteil (1,55) verbindbar ist,
zumindest eine Übergabe-Steckereinrichtung, die ein jeweiliges erstes und zweites Steckverbinderteil (21,23,61) umfasst und deren jeweiliges erstes Steckverbinderteil (23) derart in ein Gehäuseoberteil (1,51,52,53) montiert ist, dass es beim Aufsetzen dieses Gehäuseoberteils (1,51,52,53) auf das Gehäuseunterteil (2, 55) mit einem jeweiligen zweiten, zum jeweiligen ersten passenden und im Gehäuseunterteil (2, 55) montierten Steckverbinderteil (21,61) der Übergabe-Steckereinrichtung in Kontaktverbindung bringbar ist,
wobei im Gehäuseunterteil (2, 55) Verbindungseinrichtungen und/oder Anschlusseinrichtungen (22, 25) zum
Anschluß externer Leitungen, wie Klemmleisten oder dergleichen, zum Verbinden einer Verkabelung mit zumindest dem jeweiligen zweiten Steckverbinderteil (21,61) montiert sind,
**dadurch gekennzeichnet, dass**
das Gehäuseunterteil (2, 55) eine T-förmige Verkabelung für Starkstrom, wie Drehstrom, zwischen zwei externen Anschlussmöglichkeiten und einer externen Anschlussmöglichkeit für ein Hybridkabel (43) am Gehäuseunterteil (2, 55) aufweist,
und wobei das Gehäuseunterteil (2, 55) eine T-förmige Verkabelung für einen Feldbus zwischen zwei externen Anschlussmöglichkeiten am Gehäuseunterteil (1, 51, 52, 53) und zumindest einem zweiten Steckverbinderteil aufweist,
und wobei in mindestens einem Gehäuseoberteil (1,51,52,53) eine elektronische Schaltung montiert ist, die über ein erstes und zweites Steckverbinderteil mit einem Steuerbus elektrisch verbindbar ist,
und wobei das Gehäuseunterteil (2, 55) ein Hybridsteckverbinderteil (56) als externe Anschlussmöglichkeit für ein Hybridkabel mit Hybridsteckverbinderteil aufweist, das Starkstrom- und Schwachstromleitungen umfasst,
und die Schwachstromleitungen des Hybridkabels (43) mit zumindest einer elektronischen Schaltung eines Gehäuseoberteils (1,51,52,53) verbindbar sind.

2. Verteilerkasten nach Anspruch 1
**dadurch gekennzeichnet, dass**
die Schwachstromleitungen Bremsenleitungen zur Ansteuerung eines Elektromotors (46) mit Bremse umfassen und die Bremsenleitungen mit einer elektronischen Schaltung verbindbar sind, die einen Umrichter (45) umfasst und zumindest mit Steuerbusleitungen verbindbar ist.

3. Verteilerkasten nach Anspruch 1
**dadurch gekennzeichnet, dass**
die Schwachstromleitungen Steuerbusleitungen sind und die Steuerbusleitungen des Hybridkabels (43) mit den Steuerbusleitungen einer elektronischen Schaltung verbindbar sind, die mit einem Feldbus elektrisch verbunden ist.

4. Verteilerkasten nach einem der vorangegangenen Ansprüche,
**dadurch gekennzeichnet, dass** das mindestens eine Gehäuseoberteil ein Gehäuseoberteil (51) mit einer elektronische Schaltung umfasst, die elektrisch mindestens mit dem Feldbus und einem Systembus verbunden ist.

5. Verteilerkasten nach einem der vorangegangenen Ansprüche,
**dadurch gekennzeichnet, dass** das mindestens eine Gehäuseoberteil ein Gehäuseoberteil (52) zur Bildung eines abgeschlossenen Raumbereiches aufweist.

6. Verteilerkasten nach einem der vorangegangenen Ansprüche,
**dadurch gekennzeichnet, dass** das mindestens eine Gehäuseoberteil ein Gehäuseoberteil (53) mit einer elektronische Schaltung umfasst, die elektrisch mindestens mit einem Systembus und Bremsenleitungen verbindbar ist.

7. Verteilerkasten nach Anspruch 6,
**dadurch gekennzeichnet, dass**
das Gehäuseunterteil (2, 55) einen Bremswiderstand eines Umrichters (45) umfasst und der Bremswiderstand mit der elektronischen Schaltung des Gehäuseoberteils (53) verbunden ist.

8. Verteilerkasten nach einem der vorangegangenen Ansprüche,
**dadurch gekennzeichnet, dass**
die jeweilige Übergabe-Steckereinrichtung die einzige elektrische Verbindung zwischen der Verkabelung im Gehäuseunterteil (2, 55) und der elektronischen Schaltung im jeweiligen Gehäuseoberteil (1,51,52,53) darstellt.

9. Verteilerkasten nach einem der Ansprüche 1 bis 7,
**dadurch gekennzeichnet, dass**
die jeweilige Übergabe-Steckereinrichtung und ein Erdungsverbindungskabel die einzigen elektrischen Verbindungen zwischen der Verkabelung im Gehäuseunterteil (2,55) und der elektronischen Schaltung im jeweiligen Gehäuseoberteil (1,51,52,53) darstellt.

10. Verteilerkasten nach einem der vorangegangenen Ansprüche,
**dadurch gekennzeichnet, dass**
zu den Feldbus-Leitungen und / oder Steuerbusleitungen auch Leitungen für Versorgungsspannungen gehören.

11. Verteilerkasten nach einem der vorangegangenen Ansprüche,
**dadurch gekennzeichnet, dass**
das Gehäuseunterteil (2, 55) einen Motorschutzschalter (31,54), insbesondere zum elektrischen Auftrennen von Starkstromleitungen, aufweist.

12. Verteilerkasten nach Anspruch 11,
**dadurch gekennzeichnet, dass**
das Gehäuseunterteil (2, 55) einen Hilfsschalter, insbesondere zum elektrischen Auftrennen von Motorsteuerleitungen und/oder Schwachstromleitungen, aufweist, der an den Motorschutzschalter (31,54) mechanisch angekoppelt ist.

13. Verteilerkasten nach Anspruch 4,
**dadurch gekennzeichnet, dass**
die elektronische Schaltung derart gestaltet ist, dass sie als Busteilnehmer adressierbar ist und die für diese Adresse bestimmten Daten aus dem Feldbus herausfiltern kann und umsetzen kann in ein Steuerbusprotokoll und dieses über den Steuerbus an mindestens ein vom Verteilerkasten versorgte Feldgerät weitergeben kann.

14. Verteilerkasten nach Anspruch 13,
**dadurch gekennzeichnet, dass**
die elektronische Schaltung einstellbare Schalter, wie DIP-Schalter oder dergleichen, zum Einstellen der Feldbus-Adresse aufweist.

15. Verteilerkasten nach einem der vorangegangenen Ansprüche,
**dadurch gekennzeichnet, dass**
zumindest ein Gehäuseoberteil (1,51,52,53) Anschlusseinrichtungen zum Anschluss externer Sensoren und /oder Aktoren aufweist.

16. Verteilerkasten nach einem der vorangegangenen Ansprüche,
**dadurch gekennzeichnet, dass**
zumindest ein Gehäuseoberteil (1,51,52,53) eine Anschlusseinrichtung für ein Bediengerät, insbesondere ein Rechengerät wie PC oder dergleichen, insbesondere zum Einspielen von SPS-Programmen, Steuerprogrammen, Daten oder dergleichen und /oder Einrichtungen zum Ausgeben und/oder Anzeigen von Daten, wie Zuständen von Sensoren, Aktoren oder Antrieben, aufweist.

17. Verteilerkasten nach einem der vorangegangenen Ansprüche,
**dadurch gekennzeichnet, dass**
zumindest ein Gehäuseoberteil (1,51,52,53) Anzeigeeinrichtungen, wie LEDs und/oder LCD-Displays oder dergleichen, umfasst.

18. Verteilerkasten nach einem der vorangegangenen Ansprüche,
**dadurch gekennzeichnet, dass**
zumindest ein Gehäuseoberteil (1,51,52,53) Bedienelemente, wie Tasten, Drucktasten, Drehknöpfe oder dergleichen, zur Eingabe und/oder Steuerung von Abläufen umfasst.

## Claims

1. Distributor box having at least one electronic circuit, in particular comprising a microprocessor, a memory and logic units and/or power semiconductor components, having a housing comprising:
a lower housing part (2, 55),
at least one upper housing part (1, 51, 52, 53) that can be joined tightly and securely to the lower housing part (1, 55), that is to say with a high degree of protection,
at least one interface connector device that comprises a respective first and second plug connector part (21, 23, 61) and whose respective first plug connector part (23) is mounted in an upper housing part (1, 51, 52, 53) in such a way that it can be brought into contact connection when said upper housing part (1, 51, 52, 53) is mounted on the lower housing part (2, 55) with a respective second plug connector part (21, 61), mounted in the lower housing part (2, 55) so as to fit the respective first plug connection part, of the interface connector device,
wherein connecting devices and/or terminal devices (22, 25) for connecting external conductors, such as terminal strips or the like, for connecting a cabling to at least the respective second plug connector part (21, 61) are mounted in the lower housing part (2, 55),
**characterized in that**
the lower housing part (2, 55) has a T-configured cabling for heavy current, such as three-phase current, between two external connection facilities and an external connection facility for a hybrid cable (43) on the lower housing part (2, 55),
and wherein the lower housing part (2, 55) has a T-configured cabling for a field bus between two external connection facilities on the lower housing part (1, 51, 52, 53) and at least a second plug connector part,
and wherein in at least one upper housing part (1, 51, 52, 53), an electronic circuit is mounted that can be connected electrically via a first and a second plug connector part to a control bus,
and wherein the lower housing part (2, 55) has a hybrid plug connector part (56) as external connection facility for a hybrid cable with hybrid plug connector part that comprises heavy-current and light-current conductors,
and the light-current conductors of the hybrid cable (43) can be connected to at least one electronic circuit of an upper housing part (1, 51, 52, 53).

2. Distributor box according to Claim 1, **characterized in that** the light-current conductors comprise brake conductors for controlling an electric motor (46) having a brake and the brake conductors can be connected to an electronic circuit that comprises a converter (45) and can be connected at least to control-bus conductors.

3. Distributor box according to Claim 1, **characterized in that** the light-current conductors are control-bus conductors and the control-bus conductors of the hybrid cable (43) can be connected to the control-bus conductors of an electronic circuit that is electrically connected to a field bus.

4. Distributor box according to any of the preceding claims, **characterized in that** the at least one upper housing part comprises an upper housing part (51) having an electronic circuit that is electrically connected at least to the field bus and a system bus.

5. Distributor box according to any of the preceding claims, **characterized in that** the at least one upper housing part has an upper housing part (52) for forming a sealed space region.

6. Distributor box according to any of the preceding claims, **characterized in that** the at least one upper housing part comprises an upper housing part (53) containing an electronic circuit that can be connected electrically at least to a system bus and brake conductors.

7. Distributor box according to Claim 6, **characterized in that** the lower housing part (2, 55) comprises a brake resistor of a converter (45) and the brake resistor is connected to the electronic circuit of the upper housing part (53).

8. Distributor box according to any of the preceding claims, **characterized in that** the respective interface connector device is the only electrical connection between the cabling in the lower housing part (2, 55) and the electronic circuit in the respective upper housing part (1, 51, 52, 53).

9. Distributor box according to any of Claims 1 to 7, **characterized in that** the respective interface connector device and an earth connection cable are the only electrical connections between the cabling in the lower housing part (2, 55) and the electronic circuit in the respective upper housing part (1, 51, 52, 53).

10. Distributor box according to any of the preceding claims, **characterized in that** the field-bus conductors and/or control-bus conductors also include conductors for supply voltages.

11. Distributor box according to any of the preceding claims, **characterized in that** the lower housing part (2, 55) has a motor-protection switch (31, 54) in particular for electrically open-circuiting heavy-current conductors.

12. Distributor box according to Claim 11, **characterized in that** the lower housing part (2, 55) has an auxiliary switch, in particular for electrically open-circuiting motor-control conductors and/or low-current conductors that is mechanically coupled to the motor-protection switch (31, 54).

13. Distributor box according to Claim 4, **characterized in that** the electronic circuit is configured in such a way that it can be addressed as a bus node and can filter data intended for said address out of the field bus and can convert it into a control-bus protocol and can pass the latter via the control bus to at least one field appliance supplied by the distributor box.

14. Distributor box according to Claim 13, **characterized in that** the electronic circuit has settable switches, such as DIP switches or the like, for setting the field-bus address.

15. Distributor box according to any of the preceding claims, **characterized in that** at least one upper housing part (1, 51, 52, 53) has terminal devices for connecting external sensors and/or actuators.

16. Distributor box according to any of the preceding claims, **characterized in that** at least one upper housing part (1, 51, 52, 53) has a terminal device for an operating appliance, in particular, a computer appliance, such as PC or the like, in particular for loading SPS programs, control programs, data or the like and/or devices for outputting and/or displaying data, such as states of sensors, actuators or drives.

17. Distributor box according to any of the preceding claims, **characterized in that** at least one upper housing part (1, 51, 52, 53) comprises indicating devices, such as LEDs and/or LCD displays or the like.

18. Distributor box according to any of the preceding claims, **characterized in that** at least one upper housing part (1, 51, 52, 53) comprises operating elements, such as keys, pushbuttons, rotary knobs or the like, for inputting and/or controlling sequences.

## Revendications

1. Boîte de distribution avec au moins un circuit électronique, comprenant au moins un microprocesseur, une mémoire et des composants logiques et/ou des composants à semi-conducteurs de puissance, avec un boîtier comprenant
une partie inférieure de boîtier (2, 55),
au moins une partie supérieure de boîtier (1, 51, 52, 53) qui peut être reliée de manière étanche et fixe, c'est-à-dire dans un type de protection élevée, à la partie inférieure de boîtier (1, 55),
au moins un dispositif à connecteur de transfert qui comprend une première et une deuxième partie respective d'un connecteur à fiches (21, 23, 61) et dont la première partie respective du connecteur à fiches (23) est montée dans une partie supérieure de boîtier (1, 51, 52, 53) de manière que lorsque l'on place cette partie supérieure de boîtier (1, 51, 52, 53) sur la partie inférieure de boîtier (2, 55), elle puisse être amenée en contact de liaison avec une deuxième partie respective de connecteur à fiches (21, 61) adaptée à la première partie respective et montée dans la partie inférieure de boîtier (2, 55), du dispositif à connecteur de transfert,
dans laquelle, dans la partie inférieure de boîtier (2, 55) sont montés des dispositifs de liaison et/ou dispositifs de connexion (22, 25) pour la connexion de lignes externes, tels que des barrettes de bornes ou similaires, pour la liaison d'un câblage avec au moins la deuxième partie respective du connecteur à fiches (21, 61),
**caractérisée en ce que**
la partie inférieure de boîtier (2, 55) comporte un câblage en T pour courant fort, tel que courant alternatif, entre deux possibilités externes de connexion et une possibilité externe de connexion pour un câble hybride (43) sur la partie inférieure de boîtier (2, 55),
et dans laquelle la partie inférieure de boîtier (2, 55) comporte un câblage en T pour un bus de champ entre deux possibilités externes de connexion sur la partie inférieure de boîtier (1, 51, 52, 53) et au moins une deuxième partie de connecteur à fiches,
et dans laquelle dans au moins une partie inférieure de boîtier (1, 51, 52, 53) est monté un circuit électronique qui peut être relié électriquement à un bus de commande par une première et une deuxième partie de connecteur à fiches,
et dans laquelle la partie inférieure de boîtier (2, 55) comprend une partie de connecteur à fiches hybride (56) comme possibilité externe de connexion pour un câble hybride, avec partie de connecteur à fiches hybride qui comprend des lignes à courant fort et courant faible,
et les lignes à courant faible du câble hybride (43) peuvent être reliées à au moins un circuit électronique d'une partie supérieure de boîtier (1, 51, 52, 53).

2. Boîte de distribution selon la revendication 1,
**caractérisée en ce que**
les lignes à courant faible comprennent des lignes de freinage pour la commande d'un moteur électrique (46) avec frein et les lignes de freinage peuvent être reliées à un circuit électronique qui comprend un redresseur (45) et qui peut être relié au moins à des lignes de bus de commande.

3. Boîte de distribution selon la revendication 1,
**caractérisée en ce que**
les lignes à courant faible sont des lignes de bus de commande et les lignes de bus de commande du câble hybride (43) peuvent être reliées aux lignes de bus de commande d'un circuit électronique qui est relié électriquement à un bus de champ.

4. Boîte de distribution selon l'une des revendications précédentes, **caractérisée en ce que** la ou les parties supérieures de boîtier comprennent une partie supérieure de boîtier (51) avec un circuit électronique qui est relié électriquement au moins au bus de champ et à un bus du système.

5. Boîte de distribution selon l'une des revendications précédentes, **caractérisée en ce que** la ou les parties supérieures de boîtier comportent une partie supérieure de boîtier (52) pour former un volume spatial fermé.

6. Boîte de distribution selon l'une des revendications précédentes, **caractérisée en ce que** la ou les parties supérieures de boîtier comprennent une partie supérieure de boîtier (53) avec un circuit électronique qui peut être relié électriquement au moins à un bus du système et à des lignes de freinage.

7. Boîte de distribution selon la revendication 6,
**caractérisée en ce que**
la partie inférieure de boîtier (2, 55) comprend une résistance de freinage d'un mutateur (45) et la résistance de freinage est reliée au circuit électronique de la partie supérieure de boîtier (53).

8. Boîte de distribution selon l'une des revendications précédentes,
**caractérisée en ce que**
le dispositif à connecteur de transfert respectif constitue la seule liaison électrique entre le câblage dans la partie inférieure de boîtier (2, 55) et le circuit électronique dans la partie supérieure de boîtier (1, 51, 52, 53) respective.

9. Boîte de distribution selon l'une des revendications 1 à 7,
**caractérisée en ce que**
le dispositif à connecteur de transfert respectif et un câble de liaison de terre constituent les seules liaisons électriques entre le câblage dans la partie inférieure de boîtier (2, 55) et le circuit électronique dans la partie supérieure de boîtier (1, 51, 52, 53) respective.

10. Boîte de distribution selon l'une des revendications précédentes,
**caractérisée en ce que**
des lignes pour des tensions d'alimentation font aussi partie des lignes de bus de champ et/ou des lignes de bus de commande.

11. Boîte de distribution selon l'une des revendications précédentes,
**caractérisée en ce que**
la partie inférieure (2, 55) comporte un disjoncteur de protection (31, 54) du moteur, en particulier pour la séparation électrique de lignes à courant fort.

12. Boîte de distribution selon la revendication 11,
**caractérisée en ce que**
la partie inférieure de boîtier (2, 55) comporte un interrupteur auxiliaire, en particulier pour la séparation électrique de lignes de commande de moteur et/ou de lignes à courant faible, qui est accouplé mécaniquement au disjoncteur de protection (31, 54) du moteur.

13. Boîte de distribution selon la revendication 4,
**caractérisée en ce que**
le circuit électronique est conçu de manière qu'il puisse être adressé comme participant de bus et qu'il puisse filtrer les données destinées à cette adresse du bus de champ et les convertir dans un protocole de bus de commande, et de manière qu'il puisse transmettre celui-ci, à travers le bus de commande, à au moins un appareil inducteur alimenté par la boîte de distribution.

14. Boîte de distribution selon la revendication 13,
**caractérisée en ce que**
le circuit électronique comporte des interrupteurs réglables, tels que des interrupteurs DIP ou similaires, pour le réglage de l'adresse du bus de champ.

15. Boîte de distribution selon l'une des revendications précédentes,
**caractérisée en ce qu'**
au moins une partie supérieure de boîtier (1, 51, 52, 53) comporte des dispositifs de connexion pour la connexion de capteurs externes et/ou d'actionneurs.

16. Boîte de distribution selon l'une des revendications précédentes,
**caractérisée en ce qu'**
au moins une partie supérieure de boîtier (1, 51, 52, 53) comporte un dispositif de connexion pour un appareil de commande, en particulier un ordinateur tel que PC ou similaire, en particulier pour l'enregistrement de programmes d'automates programmables, de programmes de commande, de données ou similaires et/ou des dispositifs de sortie et/ou d'affichage de données, tels que des états de capteurs, actionneurs ou dispositifs d'entraînement.

17. Boîte de distribution selon l'une des revendications précédentes,
**caractérisée en ce qu'**
au moins une partie supérieure de boîtier (1, 51, 52, 53) comprend des dispositifs d'affichage tels que des LED et/ou des écrans LCD ou similaires.

18. Boîte de distribution selon l'une des revendications précédentes,
**caractérisée en ce qu'**
au moins une partie supérieure de boîtier (1, 51, 52, 53) comprend des éléments de commande tels que touches, boutons-poussoirs, boutons tournants ou similaires, pour la sélection et/ou la commande de processus.
